# EUROPÄISCHE PATENTSCHRIFT

(11) **EP 3 543 660 B1**
(45) Veröffentlichungstag und Bekanntmachung des Hinweises auf die Patenterteilung: **15.04.2020**
(21) Anmeldenummer: 18163330.6
(22) Anmeldetag: 22.03.2018
(51) Int. Cl.: G01F 23/26, G01F 25/00

(54) **IMPEDANZGRENZSCHALTER ZUR REDUZIERUNG DER EMV-ABSTRAHLUNG UND VERFAHREN ZUM BESTIMMEN EINES GRENZSTANDS EINES MEDIUMS DURCH EINEN IMPEDANZGRENZSCHALTER**
IMPEDANCE LIMIT SWITCH FOR REDUCING EMI EMISSIONS AND METHOD FOR DETERMINING A LIMIT LEVEL OF A MEDIUM THROUGH AN IMPEDANCE LIMIT SWITCH
INTERRUPTEUR DE LIMITE D'IMPÉDANCE PERMETTANT DE RÉDUIRE LES ÉMISSIONS MESURÉES EN CEM ET PROCÉDÉ DE DÉTERMINATION DU NIVEAU LIMITE D'UN MILIEU VIA UN INTERRUPTEUR DE LIMITE D'IMPÉDANCE

(43) Veröffentlichungstag der Anmeldung: 25.09.2019
(73) Patentinhaber: VEGA Grieshaber KG, 77709 Wolfach (DE)
(72) Erfinder: FEHRENBACH, Dominik, 78628 Rottweil (DE); HAAS, Jürgen, 77709 Oberwolfach (DE); WEINZIERLE, Christian, 77709 Wolfach (DE); ALLGAIER, Volker, 77716 Haslach i. K. (DE)
(74) Vertreter: Maiwald Patent- und Rechtsanwaltsgesellschaft mbH

(56) Entgegenhaltungen:
- EP-A1- 0 881 475
- EP-A1- 3 118 591
- DE-A1-102009 060 742

## Beschreibung

### Gebiet der Erfindung

Die Erfindung betrifft die Grenzstandmessung. Insbesondere betrifft die Erfindung einen Impedanzgrenzschalter, eingerichtet zur Bestimmung eines Grenzstands eines Mediums, ein Verfahren zum Bestimmen eines Grenzstands eines Mediums durch einen Impedanzgrenzschalter, ein Programmelement und ein computerlesbares Medium.

### Hintergrund

Grenzstandschalter werden eingesetzt, um einen Grenzstand eines Füllguts in oder außerhalb eines Behälters zu detektieren. Typische Anwendungen für die Erfassung einer solch vordefinierten Füllhöhe sind beispielsweise Prozesstanks, Lagertanks, Silos oder Rohrleitungen in der Prozessindustrie. Grenzstandschalter werden in unterschiedlichsten Flüssigkeiten, sowie granulierten und pulverförmigen Schüttgütern eingesetzt.

Je nach Eigenschaft des Füllguts sowie den individuellen Prozessbedingungen kommen unterschiedliche Grenzstandschalter zum Einsatz. Bekannt sind beispielsweise Impedanzgrenzschalter, TDR-Melder, Vibrationsgrenzschalter und Sensoren, die nach dem kapazitiven oder resistiven/konduktiven Messprinzip arbeiten.

Ein vom Grenzstandschalter abgesetzter Schaltbefehl startet oder stoppt Befülleinrichtungen bzw. Entleereinrichtungen, wie Förderbänder oder Pumpen.

Impedanzgrenzschalter erzeugen ein elektrisches Feld, das in das Innere des Tanks hineinreicht. Die hiermit verbundene EMV-Abstrahlung darf in manchen Anwendungen einen zulässigen Grenzwert nicht überschreiten.

DE 10 2009 060 742 A1 beschreibt eine Einrichtung zum Erkennen eines Pegelstands von Medien in einem Tank. Die Einrichtung umfasst einen länglichen elektrischen Sondenleiter, einen elektrischen zeitlich variablen Generator mit einer Innenimpedanz zum Anschließen an einen Speisepunkt des Sondenleiters und eine Auswerte- und/oder Steuereinheit, die zur Messung einer Fußpunktimpedanz des Sondenleiters am Speisepunkt ausgebildet ist.

EP 3 118 591 A1 beschreibt ein Füllstandmessgerät, insbesondere einen Füllstandgrenzschalter, mit einer Steuerungs- und Auswerteelektronik, einem Signalgenerator, einem Signaldetektor, einer resonanten Messsonde und einem Verbindungselement.

EP 0 881 475 A1 beschreibt eine Vorrichtung zur Bestimmung einer Menge eines Verbrauchsmaterials, insbesondere einer Tinte, in einem Behälter mit einem Kondensator.

### Zusammenfassung der Erfindung

Es ist eine Aufgabe der Erfindung, einen Impedanzgrenzschalter anzugeben, der in unterschiedlichen Messumgebungen zuverlässig einsetzbar ist.

Diese Aufgabe wird durch die Merkmale der unabhängigen Patentansprüche gelöst. Weiterbildungen der Erfindung ergeben sich aus den Unteransprüchen und der folgenden Beschreibung.

Ein erster Aspekt der Erfindung betrifft einen Impedanzgrenzschalter, der zur Bestimmung eines Grenzstandes eines Mediums in einem Behälter eingerichtet ist. Er weist eine Messsonde und eine Elektronikschaltung auf.

Die Messsonde kann insbesondere eine Messelektrode, eine Bezugselektrode und eine Induktivität aufweisen. Darüber hinaus kann eine Schirmelektrode vorgesehen sein, die dafür sorgt, dass die elektrischen Feldlinien möglichst tief in das Füllgut eindringen.

Die Elektronikschaltung ist eingerichtet, ein Anregungssignal für einen Schwingkreis, der typischer Weise die Messelektrode, die Bezugselektrode und die Induktivität aufweist, zu erzeugen und in den Schwingkreis einzuspeisen. Des Weiteren ist die Elektronikschaltung eingerichtet, die Frequenz dieses Anregungssignals beispielsweise in Form eines stufenlosen oder gestuften Sweeps durchzufahren und eine Resonanzkurve des Schwingkreises zu bestimmen.

Darüber hinaus kann die Elektronikschaltung die Amplitude bzw. Spannung des Anregungssignals in Abhängigkeit von der Resonanzkurve anpassen, typischer Weise, indem die Spannung eines Sendesignals, das in einen VCO eingespeist wird, der das Anregungssignal erzeugt, angepasst wird, um die EMV-Abstrahlung des Impedanzgrenzschalters zu reduzieren.

Ändert sich die Resonanzkurve, hat sich im Regelfall das Anregungssignal geändert, da dieses ja für die Form und die Amplitude der Resonanzkurve verantwortlich ist. Insbesondere kann vorgesehen sein, dass die Amplitude des Anregungssignals, und damit die Spannung des Sendesignals, in Abhängigkeit von der Frequenz variiert wird. Diese Änderung der Amplitude des Anregungssignals bzw. der Spannung des Sendesignals über die Frequenz kann hierbei der Form der Resonanzkurve entsprechen. So führt eine starke Änderung der Amplitude der Resonanzkurve in diesem Fall dazu, dass in diesem Frequenzbereich das Anregungssignal stark geändert wird, und umgekehrt.

Diese Maßnahmen können dazu führen, dass sich die EMV-Abstrahlung des Impedanzgrenzschalters ohne Verschlechterung oder zumindest ohne deutliche Verschlechterung der Empfindlichkeit der Impedanzmessung reduziert.

Insbesondere kann eine adaptive Regelung des Anregungssignals (indirekt über die adaptive Regelung der Sendesignalspannung) zur Minimierung der Störabstrahlung vorgesehen sein.

Gemäß einer Ausführungsform ist die Elektronikschaltung eingerichtet, die Amplitude des Anregungssignals schrittweise über eine Regelschleife anzupassen. Es handelt sich in diesem Fall um ein iteratives, adaptives Verfahren, welches eingesetzt werden kann, um die EMV Abstrahlung möglichst nahe an den Grenzwert anzunähern.

Gemäß einer Ausführungsform der Erfindung ist die Elektronikschaltung eingerichtet, dafür Sorge zu tragen, dass ein Tiefpunkt in der Resonanzkurve zu einer Verringerung der Amplitude des Anregungssignals bei der Frequenz des Tiefpunkts führt. Diese Überlegung basiert auf der Erkenntnis, dass der Peak in der Resonanzkurve zu einer erhöhten EMV-Abstrahlung führen kann. Wird nun die Frequenz dieses Peaks und seiner Amplitude identifiziert, kann durch eine Verringerung der Amplitude des Anregungssignals im Bereich des Peaks erreicht werden, dass bei diesen Frequenzen die EMV-Abstrahlung abnimmt und, im Idealfall, denselben Wert hat wie in anderen Bereichen der Resonanzkurve.

Gemäß einer weiteren Ausführungsform der Erfindung ist die Elektronikschaltung eingerichtet, die Amplitude des Anregungssignals derart zu regeln, dass die EMV-Abstrahlung des Impedanzgrenzschalters über den durchgefahrenen Frequenzbereich des Anregungssignals im Wesentlichen konstant ist oder zumindest nur Schwankungen aufweist, die unterhalb eines vorbestimmten Grenzwerts liegen. Es kann vorgesehen sein, dass dieser Grenzwert vom Benutzer eingebbar ist.

Darüber hinaus kann vorgesehen sein, dass die Elektronikschaltung die Amplitude des Anregungssignals derart regelt, dass die maximale EMV-Abstrahlung des Impedanzgrenzschalters unterhalb eines definierten Grenzwerts liegt. Wie oben kann vorgesehen, dass dieser Grenzwert vom Benutzer eingebbar ist.

Gemäß einer weiteren Ausführungsform der Erfindung ist die Elektronikschaltung eingerichtet, die Amplitude des Anregungssignals derart zu regeln, dass die EMV-Abstrahlung des Impedanzgrenzschalters nahe bei, aber noch immer unterhalb des definierten Grenzwerts liegt. So kann vorgesehen sein, dass die Regelung nach der Analyse der ersten aufgenommenen Resonanzkurve das Anregungssignal deutlich herabregelt und dann, schrittweise, zumindest abschnittsweise wieder hochregelt, so dass einerseits die Impedanzkurve immer glatter wird (der Peak entwickelt sich zurück) und andererseits sich die Amplitude der Resonanzkurve einem Wert annähert, der dem Grenzwert der zulässigen EMV-Abstrahlung entspricht.

Vorteilhafter Weise ist der Zusammenhang zwischen Form und Amplitude der Resonanzkurve und der damit zusammenhängenden EMV-Abstrahlung bekannt, so dass das Anregungssignal entsprechend optimal eingestellt werden kann.

Ein weiterer Aspekt der Erfindung betrifft ein Verfahren zum Bestimmen eines Grenzstands eines Mediums in einem Behälter durch einen Impedanzgrenzschalter. Zunächst wird ein Anregungssignal für einen Schwingkreis des Impedanzgrenzschalters erzeugt. Der Schwingkreis weist typischerweise eine Messelektrode, eine Bezugselektrode und eine Induktivität auf. Danach wird die Frequenz des Anregungssignals durchgefahren (Sweep) und die Resonanzkurve des Schwingkreises wird bestimmt. Danach erfolgt eine Anpassung der Amplitude des Anregungssignals in Abhängigkeit von der Resonanzkurve, insbesondere von der Form und der Amplitude der Resonanzkurve, um eine EMV-Abstrahlung des Impedanzgrenzschalters zu reduzieren und nach Möglichkeit über den gesamten Frequenzbereich des Sweeps möglichst konstant zu halten.

Ein weiterer Aspekt der Erfindung betrifft ein Programmelement, das, wenn es auf einem Prozessor eines Impedanzgrenzschalters ausgeführt wird, den Impedanzgrenzschalter anweist, das oben und im Folgenden beschriebene Verfahren durchzuführen.

Ein weiterer Aspekt der Erfindung betrifft ein computerlesbares Medium, auf dem das oben beschriebene Programmelement gespeichert ist.

Im Folgenden werden unter Bezugnahme auf die Figuren Ausführungsformen der Erfindung beschrieben. Die Darstellungen in den Figuren sind schematisch und nicht maßstäblich. Werden in den folgenden Figuren die gleichen Bezugszeichen verwendet, so bezeichnen diese gleiche oder ähnliche Elemente.

### Kurze Beschreibung der Figuren

Fig. 1 zeigt das Ansteuerungssignal einer DAC-Schaltung.
Fig. 2 zeigt die entsprechende, von einem VCO ausgegebene Frequenz.
Fig. 3 zeigt eine Resonanzkurve eines Impedanzgrenzschalters.
Fig. 4 zeigt die EMV-Abstrahlung eines Impedanzgrenzschalters.
Fig. 5 zeigt ein Anregungssignal (Sendespannung) eines Schwingkreises eines Impedanzgrenzschalters.
Fig. 6 zeigt weitere Anregungssignale eines Impedanzgrenzschalters.
Fig. 7 zeigt EMV-Abstrahlungen eines Impedanzgrenzschalters während und nach der erfolgten Regelung des Anregungssignals.
Fig. 8 zeigt ein Blockschaltbild eines Impedanzgrenzschalters.
Fig. 9 zeigt ein Blockschaltbild eines weiteren Impedanzgrenzschalters.
Fig. 10 zeigt einen Impedanzgrenzschalter.
Fig. 11 zeigt ein Flussdiagramm eines Verfahrens.

### Detaillierte Beschreibung von Ausführungsformen

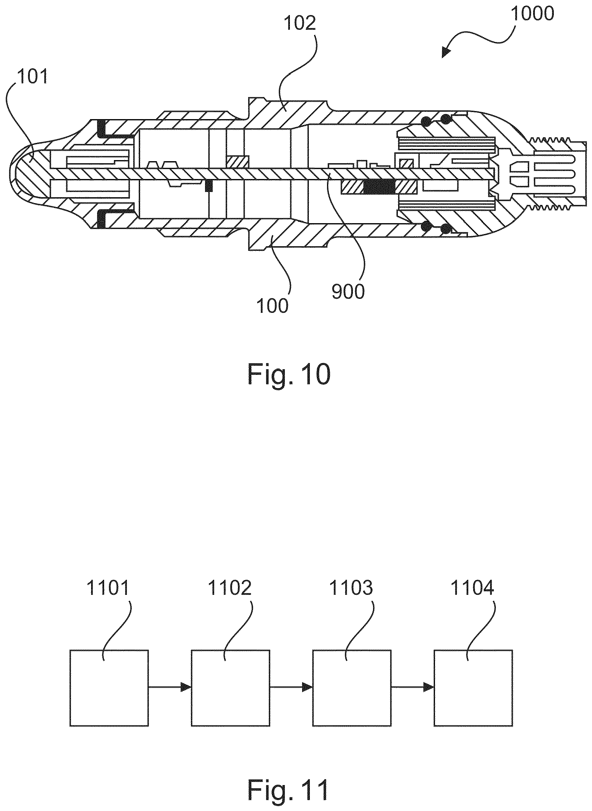

Fig. 10 zeigt einen Impedanzgrenzschalter 1000. Der Impedanzgrenzschalter weist eine Elektronikschaltung 900 (Elektronikeinheit) auf, die ein Anregungssignal für den Schwingkreis der Messsonde 100 erzeugt. Zwischen der Messelektrode 101 und der Bezugselektrode 102 bildet sich eine Messkapazität aus, welche mit einer diskreten Induktivität (nicht dargestellt) eine Serienresonanz erzeugt.

Der Betrag der komplexen Impedanz dieses Schwingkreises wird beispielsweise zwischen 100 MHz und 200 MHz analysiert. Befindet sich ein Füllgut (Medium) im Bereich der Messsonde, so ändert sich das Impedanzverhalten. Genau diese Änderung der Impedanz wird für die Auswertung herangezogen. Im Speziellen wird das Minimum der Resonanzkurve bezüglich Frequenzänderung und Amplitudenänderung ausgewertet und daraus ein Schaltbefehl generiert. Die Erzeugung der Schwingfrequenz wird mit einem spannungsgesteuerten Oszillator (VCO, Voltage Controlled Oscillator) erzeugt. Diese Schwingfrequenz verursacht bedingt durch das Messprinzip eine EMV-Abstrahlung im Arbeitsbereich. Es müssen Maßnahmen ergriffen werden, damit die EMV-Abstrahlung im Arbeitsbereich die zulässigen Grenzwerte nicht überschreitet. Im Folgenden wird auf geeignete Maßnahmen, welche vorzugsweise die Messfunktionalität nicht negativ beeinflussen, eingegangen, um die EMV-Abstrahlung im Arbeitsbereich unter den zulässigen Grenzwerten zu halten.

Die EMV-Abstrahlung wird reduziert, indem die Elektronikschaltung 900 die Sendespannung (also das Anregungssignal für den Schwingkreis) adaptiv an den Resonanzverlauf des Schwingkreises anpasst, wobei die Messfunktionalität bzw. Empfindlichkeit des Grenzschalters nach Möglichkeit nicht negativ beeinflusst wird.

Nach der Reduzierung der EMV-Abstrahlung kann die Amplitude der Resonanzfrequenz so weit erhöht werden, dass der zulässige Grenzwert für die EMV-Abstrahlung gerade noch eingehalten wird. Hierdurch wird die Abstrahlung verringert und die Störfestigkeit gegenüber Einstrahlung (von außen) maximiert.

Ein Kerngedanke kann darin gesehen werden, dass die EMV-Abstrahlung des Impedanzgrenzschalters nach Möglichkeit ohne Verschlechterung der Empfindlichkeit des Messgeräts reduziert wird.

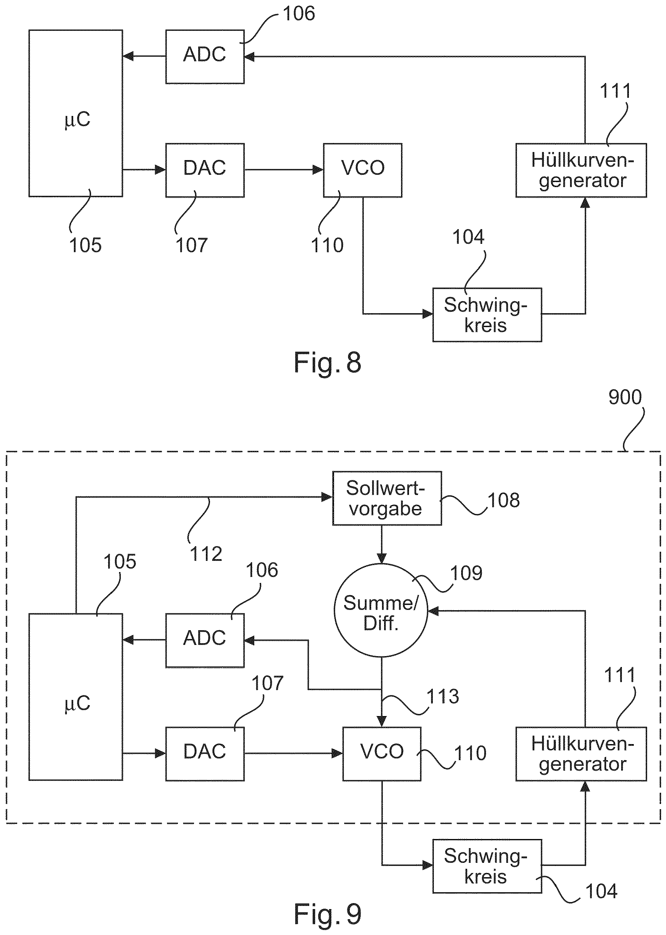

Die Erzeugung der Schwingfrequenz des Schwingkreises erfolgt mit dem VCO 110 (vgl. Fig. 9), der über einen Digital-Analog-Converter (DAC) 107 des Mikrocontrollers (Prozessor) 105 angesteuert wird. In einer Zeit von beispielsweise 100 ms soll der Frequenzbereich von 100 MHz bis 200 MHz durchgefahren (durchgesweept) werden.

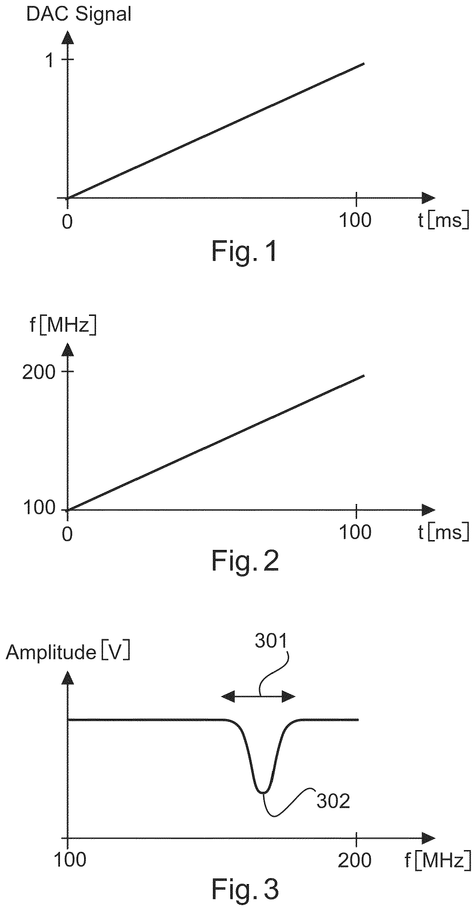

Fig. 1 zeigt ein typisches Ansteuersignal vom Prozessor 105 an den DAC 107. Das DAC-Signal verläuft linear von beispielsweise t=0 bis t=100 ms von einem Wert 0 bis zu einem Wert 1.

Ein eingestellter DAC-Wert ergibt eine entsprechende VCO-Spannung und diese wiederum eine VCO-Ausgabefrequenz, die in den Schwingkreis 104 (siehe Fig. 9) eingespeist wird.

Fig. 2 zeigt die VCO-Frequenz, die der VCO ausgibt, wenn er mit dem DAC-Signal der Fig. 1 beaufschlagt wird. Auch hier läuft die Zeit von t=0 ms bis t=100 ms. Die Frequenz beginnt beispielsweise bei 100 MHz und läuft bis 200 MHz.

Das Signal des VCO wird auf den Schwingkreis 104 des Impedanzgrenzschalters gegeben. An der Resonanzstelle 301 des Impedanzgrenzschalters erhält man in der Resonanzkurve (vgl. Fig. 3) einen Tiefpunkt 302. Die Resonanzkurve entspricht einer Hüllkurve und ergibt sich durch Abtastung des Schwingkreissignals.

Die in Fig. 3 gezeigte Resonanzkurve des Impedanzgrenzschalters bewegt sich natürlich ebenfalls zwischen 100 MHz und 200 MHz und stellt letztendlich die Spannung im Schwingkreis dar, die an der Induktivität oder der Kapazität des Schwingkreises gemessen wird.

An der Resonanzstelle ergibt sich eine Anpassung, welche dazu führt, dass die EMV-Abstrahlung an dieser Stelle am höchsten ist, da an diesem Punkt am meisten Energie durch den Schwingkreis fließt.

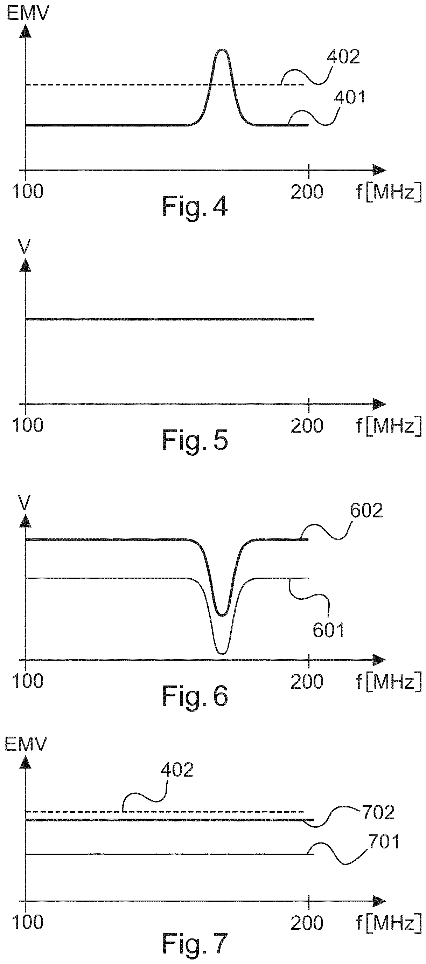

In Fig. 4 ist eine typische EMV-Abstrahlung dargestellt. Die horizontale Linie 402 zeigt den zulässigen Grenzwert an. Die EMV-Abstrahlung 401 übersteigt im Bereich des Resonanzpeaks und insbesondere im Bereich der Frequenz des Tiefpunkts 302 (Fig. 3) den Grenzwert 402 der EMV-Abstrahlung.

Die EMV-Abstrahlung, die in Fig. 4 gezeigt ist, muss im Resonanzbereich reduziert werden. Typischerweise ist die Sendespannung (Amplitude) konstant und es wird lediglich die Frequenz variiert. Dies ist in Fig. 5 gezeigt.

Passt man nun die Sendespannung, die dem VCO zugeführt wird, entsprechend der gemessenen Resonanzkurve an, kann die EMV-Abstrahlung im Bereich der Resonanz reduziert werden. Im optimalen Fall erhält man ein konstante EMV-Abstrahlung.

Die Kurve 601 der Fig. 6 zeigt eine angepasste Sendespannung und in Fig. 7 zeigt die Kurve 701 die entsprechende EMV-Abstrahlung.

Durch die geschilderte Optimierung der Sendespannung (vgl. Kurve 601 der Fig. 6) kann die EMV-Abstrahlung erhöht werden (vgl. 701 in Fig. 7), so dass aber der Grenzwert 402 noch immer nicht erreicht ist. Somit kann die Sendespannung noch weiter angepasst werden, um ein Optimum zu erreichen.

Basierend auf diesen Überlegungen lässt sich eine Regelung aufbauen, die einen konstanten Pegel des Ausgangssignals bzw. der Hüllkurve (Resonanzkurve) erzeugt. Ein Beispiel für eine entsprechende Regelungsschaltung ist in Fig. 9 gezeigt. An den Schwingkreis 104 ist ein Hüllkurvengenerator 111 angeschlossen, der die Spannung an der Kapazität des Schwingkreises oder der Induktivität des Schwingkreises misst und daraus eine Hüllkurve (Resonanzkurve) erzeugt. Es ist ein Regelelement 109 vorgesehen, das diese Hüllkurve mit einer Sollwertvorgabe 108 des Mikrocontrollers 105 vergleicht und daraus beispielsweise die Summe oder die Differenz bildet. Das Ergebnis wird als Steuersignal (Steuerspannung) in den VCO 110 eingespeist. Dieses Steuersignal regelt die vom VCO ausgegebene Signalamplitude des Anregungssignals, das in den Schwingkreis 104 eingespeist wird.

Zur gleichen Zeit wird das von der Einheit 109 erzeugte Signal an den Analog-Digital-Converter 106 der Elektronikschaltung 900 abgegeben, die daraus ein digitales Signal für den Mikrocontroller 105 erzeugt, auf Basis dessen der Mikrocontroller die Sollwertvorgabe 108 steuert. Dieses optionale, zusätzliche Steuersignal 112 vom Mikrocontroller 105 an die Sollwertvorgabeschaltung 108 kann ein Signal sein, das der "invertierten" Hüllkurve der Resonanzkurve entspricht. Da im Bereich des Resonanzpeaks bei konstanter Sendespannung 113 an den VCO die EMV-Abstrahlung erhöht ist, wird die Sollwertvorgabe in diesem Bereich geringer sein.

Die in Fig. 9 gezeigte Regelungsschaltung kann so eingestellt sein, dass die vom Hüllkurvengenerator 111 erzeugte Hüllkurve schrittweise immer glatter wird und (im Idealfall) über den gesamten Frequenzbereich weitgehend konstant ist, so dass auch die EMV-Abstrahlung über diesen Frequenzbereich konstant ist und dann über eine entsprechende Erhöhung der Sendespannung 113 an den Grenzwert von unten angenähert werden kann, ohne diesen jedoch zu erreichen.

Fig. 8 zeigt ein Schaltbild eines Impedanzgrenzstandschalters ohne die Regelung der Fig. 9.

Fig. 11 zeigt ein Flussdiagramm eines Verfahrens zur Bestimmung eines Grenzstands eines Mediums. In Schritt 1101 wird ein Anregungssignal für einen Schwingkreis erzeugt und in den Schwingkreis eingespeist. Dieses Anregungssignal wird in Schritt 1102 in der Frequenz durchgefahren und in Schritt 1103 wird die Resonanzkurve des Schwingkreises untersucht, beispielsweise indem die Spannung an der Induktivität oder der Schwingkreiskapazität abgetastet wird.

In Schritt 1104 wird die Spannung des Sendesignals, und damit die Spannung des Anregungssignals des Schwingkreises, in Abhängigkeit von Form und Amplitude der Resonanzkurve angepasst, um die EMV-Abstrahlung des Impedanzgrenzschalters zu reduzieren, über den gesamten Frequenzbereich weitgehend konstant zu halten und an einen Grenzwert von unten her anzunähern.

Ergänzend sei daraufhingewiesen, dass "umfassend" und "aufweisend" keine anderen Elemente oder Schritte ausschließt und "eine" oder "ein" keine Vielzahl ausschließt. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkungen zu sehen.

## Patentansprüche

1. Impedanzgrenzschalter (1000), eingerichtet zur Bestimmung eines Grenzstands eines Mediums, aufweisend:
eine Messsonde (100) mit einem Schwingkreis (104);
eine Elektronikschaltung (900), eingerichtet zur Erzeugung eines Anregungssignals für den Schwingkreis (104);
wobei die Elektronikschaltung weiter eingerichtet ist, die Frequenz des Anregungssignals über einen Frequenzbereich durchzufahren und eine Resonanzkurve des Schwingkreises zu bestimmen;
**dadurch gekennzeichnet, dass** die Elektronikschaltung weiter eingerichtet ist, die Amplitude des Anregungssignals in Abhängigkeit von der Resonanzkurve anzupassen, um eine EMV Abstrahlung des Impedanzgrenzschalters über den durchgefahrenen Frequenzbereich zu reduzieren.

2. Impedanzgrenzschalter nach Anspruch 1,
wobei die Elektronikschaltung (900) eingerichtet ist, die Amplitude des Anregungssignals entsprechend der Resonanzkurve anzupassen.

3. Impedanzgrenzschalter nach Anspruch 1 oder 2,
wobei die Elektronikschaltung (900) eingerichtet ist, die Amplitude des Anregungssignals schrittweise über eine Regelschleife anzupassen.

4. Impedanzgrenzschalter nach einem der vorhergehenden Ansprüche,
wobei die Elektronikschaltung (900) eingerichtet ist, dafür zu sorgen, dass ein Tiefpunkt in der Resonanzkurve zu einer Verringerung der Amplitude des Anregungssignals bei der Frequenz des Tiefpunkts führt.

5. Impedanzgrenzschalter nach einem der vorhergehenden Ansprüche,
wobei die Elektronikschaltung (900) eingerichtet ist, die Amplitude des Anregungssignals derart zu regeln, dass die EMV Abstrahlung des Impedanzgrenzschalters über den durchgefahrenen Frequenzbereich des Anregungssignals konstant ist.

6. Impedanzgrenzschalter nach einem der vorhergehenden Ansprüche,
wobei die Elektronikschaltung (900) eingerichtet ist, die Amplitude des Anregungssignals derart zu regeln, dass die EMV Abstrahlung des Impedanzgrenzschalters unterhalb eines definierten Grenzwertes liegt.

7. Impedanzgrenzschalter nach einem der vorhergehenden Ansprüche,
wobei die Elektronikschaltung (900) eingerichtet ist, die Amplitude des Anregungssignals derart zu regeln, dass die EMV Abstrahlung des Impedanzgrenzschalters nahe bei aber noch immer unterhalb eines definierten Grenzwertes liegt.

8. Verfahren zum Bestimmen eines Grenzstands eines Mediums durch einen Impedanzgrenzschalter (1000), aufweisend die folgenden Schritte:
Erzeugen eines Anregungssignals für einen Schwingkreis (104);
Durchfahren der Frequenz des Anregungssignals über einen Frequenzbereich;
Bestimmen einer Resonanzkurve des Schwingkreises;
Anpassen der Amplitude des Anregungssignals in Abhängigkeit von der Resonanzkurve, um eine EMV Abstrahlung des Impedanzgrenzschalters über den durchgefahrenen Frequenzbereich zu reduzieren.

9. Programmelement, das, wenn es auf einem Prozessor (105) eines Impedanzgrenzschalters (1000) ausgeführt wird, den Impedanzgrenzschalter anweist, die folgenden Schritte durchzuführen:
Erzeugen eines Anregungssignals für einen Schwingkreis (104);
Durchfahren der Frequenz des Anregungssignals über einen Frequenzbereich;
Bestimmen einer Resonanzkurve des Schwingkreises;
Anpassen der Amplitude des Anregungssignals in Abhängigkeit von der Resonanzkurve, um eine EMV Abstrahlung des Impedanzgrenzschalters über den durchgefahrenen Frequenzbereich zu reduzieren.

10. Computerlesbares Medium, auf dem ein Programmelement nach Anspruch 9 gespeichert ist.

## Claims

1. Impedance limit switch (1000), configured to determine a limit level of a medium, comprising:
a measuring probe (100) having an oscillator circuit (104);
an electronic circuit (900), configured to generate an excitation signal for the oscillator circuit (104);
wherein the electronic circuit is further configured to sweep the frequency of the excitation signal over a frequency range and to determine a resonance curve of the oscillator circuit;
**characterized by** that the electronic circuit is further configured to adapt the amplitude of the excitation signal dependent upon the resonance curve in order to reduce an EMC radiation of the impedance limit switch over the swept frequency range.

2. Impedance limit switch according to claim 1,
wherein the electronic circuit (900) is configured to adapt the amplitude of the excitation signal in accordance with the resonance curve.

3. Impedance limit switch according to claim 1 or 2,
wherein the electronic circuit (900) is configured to adapt the amplitude of the excitation signal in a step-wise manner by means of a control loop.

4. Impedance limit switch according to one of the preceding claims,
wherein the electronic circuit (900) is configured to ensure that a low point in the resonance curve leads to a reduction of the amplitude of the excitation signal at the frequency of the low point.

5. Impedance limit switch according to one of the preceding claims,
wherein the electronic circuit (900) is configured to regulate the amplitude of the excitation signal such that the EMC radiation of the impedance limit switch is constant over the frequency range of the excitation signal.

6. Impedance limit switch according to one of the preceding claims,
wherein the electronic circuit (900) is configured to regulate the amplitude of the excitation signal such that the EMC radiation of the impedance limit switch lies below a defined limit value.

7. Impedance limit switch according to one of the preceding claims,
wherein the electronic circuit (900) is configured to regulate the amplitude of the excitation signal such that the EMC radiation of the impedance limit switch lies close to, but still below, a defined limit value.

8. Method for determining a limit level of a medium by means of an impedance limit switch (1000), comprising the following steps:
generating an excitation signal for an oscillator circuit (104);
sweeping the frequency of the excitation signal over a frequency range;
determining a resonance curve of the oscillator circuit;
adapting the amplitude of the excitation signal dependent upon the resonance curve in order to reduce an EMC radiation of the impedance limit switch over the swept frequency range.

9. Program element which, when it is executed on a processor (105) of an impedance limit switch (1000), instructs the impedance limit switch to carry out the following steps:
generating an excitation signal for an oscillator circuit (104);
sweeping the frequency of the excitation signal over a frequency range;
determining a resonance curve of the oscillator circuit;
adapting the amplitude of the excitation signal dependent upon the resonance curve in order to reduce an EMC radiation of the impedance limit switch over the swept frequency range.

10. Computer-readable medium on which a program element according to claim 9 is stored.

## Revendications

1. Interrupteur de limite à impédance (1000), conçu pour déterminer un niveau limite d'un milieu, comportant :
une sonde de mesure (100) dotée d'un circuit oscillant (104) ;
un circuit électronique (900), conçu pour générer un signal d'excitation pour le circuit oscillant (104) ;
le circuit électronique étant en outre conçu pour passer par la fréquence du signal d'excitation en balayant une plage de fréquences et pour déterminer une courbe de résonance du circuit oscillant ;
**caractérisé en ce que** le circuit électronique est en outre conçu pour adapter l'amplitude du signal d'excitation en fonction de la courbe de résonance pour réduire des émissions mesurées en CEM de l'interrupteur de limite à impédance sur la plage de fréquences traversée.

2. Interrupteur de limite à impédance selon la revendication 1, dans lequel le circuit électronique (900) est conçu pour adapter l'amplitude du signal d'excitation conformément à la courbe de résonance.

3. Interrupteur de limite à impédance selon la revendication 1 ou 2,
dans lequel le circuit électronique (900) est conçu pour adapter l'amplitude du signal d'excitation progressivement via une boucle de régulation.

4. Interrupteur de limite à impédance selon l'une des revendications précédentes,
dans lequel le circuit électronique (900) est conçu pour faire en sorte qu'un point bas dans la courbe de résonance entraîne une diminution de l'amplitude du signal d'excitation à la fréquence du point bas.

5. Interrupteur de limite à impédance selon l'une des revendications précédentes,
dans lequel le circuit électronique (900) est conçu pour réguler l'amplitude du signal d'excitation de telle manière que les émissions mesurées en CEM de l'interrupteur de limite à impédance soient constantes sur la plage de fréquences traversée du signal d'excitation.

6. Interrupteur de limite à impédance selon l'une des revendications précédentes,
dans lequel le circuit électronique (900) est conçu pour réguler l'amplitude du signal d'excitation de telle manière que les émissions mesurées en CEM de l'interrupteur de limite à impédance soient inférieures à une valeur limite définie.

7. Interrupteur de limite à impédance selon l'une des revendications précédentes,
dans lequel le circuit électronique (900) est conçu pour réguler l'amplitude du signal d'excitation de telle manière que les émissions mesurées en CEM de l'interrupteur de limite à impédance soient proches d'une valeur limite définie mais toujours inférieures à celle-ci.

8. Procédé de détermination d'un niveau limite d'un milieu par un interrupteur de limite à impédance (1000), comportant les étapes suivantes :
génération d'un signal d'excitation pour un circuit oscillant (104) ;
passage par la fréquence du signal d'excitation en balayant une plage de fréquences ;
détermination d'une courbe de résonance du circuit oscillant ;
adaptation de l'amplitude du signal d'excitation en fonction de la courbe de résonance pour réduire des émissions mesurées en CEM de l'interrupteur de limite à impédance sur la plage de fréquences traversée.

9. Élément de programme qui, quand il est exécuté sur un processeur (105) d'un interrupteur de limite à impédance (1000), amène l'interrupteur de limite à impédance à exécuter les étapes suivantes :
génération d'un signal d'excitation pour un circuit oscillant (104) ;
passage par la fréquence du signal d'excitation en balayant une plage de fréquences ;
détermination d'une courbe de résonance du circuit oscillant ;
adaptation de l'amplitude du signal d'excitation en fonction de la courbe de résonance pour réduire des émissions mesurées en CEM de l'interrupteur de limite à impédance sur la plage de fréquences traversée.

10. Support lisible par ordinateur, sur lequel est enregistré un élément de programme selon la revendication 9.
